# EUROPÄISCHE PATENTSCHRIFT

(11) **EP 2 574 446 B1**
(45) Veröffentlichungstag und Bekanntmachung des Hinweises auf die Patenterteilung: **11.06.2014**
(21) Anmeldenummer: 11183383.6
(22) Anmeldetag: 30.09.2011
(51) Int. Cl.: B29C 59/10, B29C 59/14, H01T 19/00, H05H 1/46, B29C 55/12, H05H 1/48

(54) **Verfahren und Vorrichtung zur Beeinflussung von Oberflächeneigenschaften von Kunststofffilmen oder Metallfolien**
Method and Device for Manipulating Surface Characteristics of Plastic Films or Metal Foils
Procédé et dispositif d'influence de propriétés de surface de films en plastique ou de feuilles en métal

(43) Veröffentlichungstag der Anmeldung: 03.04.2013
(73) Patentinhaber: Softal Corona & Plasma GmbH, 21107 Hamburg (DE)
(72) Erfinder: Arlt, Gerhard, 86850 Fischach (DE); Förster, Frank, 22297 Hamburg (DE)
(74) Vertreter: Raffay & Fleck

(56) Entgegenhaltungen:
- DE-A1-102005 052 441
- US-A1- 2001 015 252
- US-A1- 2002 109 470
- US-A1- 2009 120 782

## Beschreibung

Die vorliegende Anmeldung betrifft ein Verfahren und eine Vorrichtung zur Beeinflussung von Oberflächeneigenschaften von Kunststofffilmen oder Metallfolien. Es lässt sich mit besonderem Vorteil auf biaxial gereckten Filme aus thermoplastischen Polymeren anwenden. Ferner wird eine Vorrichtung offenbart, mit der ein solches Verfahren durchgeführt werden kann.

Es ist bekannt und seit langem gängige Praxis, thermoplastische Kunststofffilme einerseits zum Erzielen der gewünschten Endmaße hinsichtlich Stärke und Breite eines solchen Films, insbesondere einer Kunststofffilmbahn, andererseits für eine gewünschte Orientierung zu recken. Hierbei werden Reckanlage verwendet, in denen teils zweistufig, in einigen Anlagen auch bereits in einem einstufigen Vorgang, Kunststofffilme, insbesondere Kunststofffilmbahnen einer Längsreckung, d.h. einer Reckung in Transport- bzw. Bahnrichtung sowie einer Querreckung, insbesondere senkrecht zu der Längsrichtung gerichtet, unterzogen werden.

Ferner ist es bekannt, zur Veränderung der Oberflächeneigenschaften von Kunststofffilmen und Metallfolien, z.B. zur Erhöhung der Oberflächenspannung und damit der Adhäsionswirkung eines Kunststofffilms oder aber auch der Reinigung der Oberfläche einer Metallfolie, diese einer Behandlung, im Falle eines Kunststofffilms insbesondere einer aktivierenden Behandlung zu unterziehen. Für solche, insbesondere aktivierenden Behandlungen sind Flammbehandlungen, Plasmabehandlungen oder Coronabehandlungen bekannt, wie auch Kombinationen solcher Behandlungen.

Das Problem ist hierbei stets, eine möglichst effiziente und hoch wirksame sowie in ihrem Bearbeitungsergebnis weitgehend beständige Oberflächenbehandlung zu vollziehen.

Eine besondere Möglichkeit, dies in Bezug auf Kunststofffilme zu unternehmen, ist in der DE 10 2005 052 441 beschrieben, die vorschlägt, bei biaxial gereckten Kunststofffilmen diese nach einem Schritt des Längsreckens, jedoch vor einem Schritt des Querreckens über ihre Breite mittels Atmosphärendruck Plasma zu behandeln, anschließend die Querreckung vorzunehmen und daran anschließend eine zweite Behandlung folgen zu lassen, bei der es sich um eine Corona- oder Flammbehandlung handelt. In dieser Druckschrift sind in der einleitenden Beschreibung auch weitere und nähere Ausführungen zum Stand der Technik und zur Wirkweise von Plasma= und Coronaentladungen gegeben, die auch für die vorliegende Erfindungsbeschreibung zutreffend und relevant sind, auf die hier insoweit verwiesen und Bezug genommen wird.

Das Verfahren, wie es in der DE 10 2005 052 441 beschrieben ist, liefert gemäß dieser Druckschrift sehr gute Ergebnisse mit hohen Oberflächenspannungen, die für eine für die spätere Verwendung des Kunststofffilms, z.B. ein Bedrucken, sehr gut geeignete Aktivierung der Filmoberfläche sprechen. Dies wird in dieser Druckschrift zurückgeführt auf die besondere Kombination aus einer (Atmosphärendruck) Plasmabehandlung nach dem Längs- aber vor dem Querrecken und einer erst nach dem Querrecken erfolgten weiteren Behandlung mittels Coronaentladung oder Flammbehandlung. Dabei stellen sich in der praktischen Umsetzung des dort beschriebenen Verfahrens jedoch folgende Probleme:

Zunächst einmal ist dieses besondere Verfahren nur bei der Herstellung von gereckten Kunststofffilmen anwendbar. Auf Metallfolien kann es nicht angewendet werden. Auch ist es nicht für eine spätere, nach der Herstellung liegende Behandlung von Kunststofffilmen geeignet, wie sie z.B. für eine erneute Oberflächenaktivierung unmittelbar vor einem weiteren Behandlungsschritt, bspw. einem Bedrucken, wünschenswert sein kann.

Ferner müssen in eine Vorrichtung zum Recken von Kunststofffilmen an zwei getrennten Positionen zusätzliche Einrichtungen integriert werden, nämlich eine erste Behandlungsstation für die Plasmabehandlung hinter einem Längsreckabschnitt der Vorrichtung, jedoch vor dem Querreckabschnitt und eine zweite Station für die Corona- oder Flammbehandlung nachfolgend dem Querreckabschnitt. Zudem kann dieses Verfahren nur bei solchen Vorgehensweisen unternommen werden, bei denen das Recken der Kunststofffilme getrennt nach Längsreckung (dieser Schritt zuerst) und Querreckung (dieser Schritt an zweiter Stelle) vorgenommen wird, also nicht bei Herstellungsverfahren mit einem Recken in Querund Längsrichtung in einem einzigen Schritt. Schließlich ist die Einrichtung für die nach dem Querrecken durchzuführende Corona- oder Flammbehandlung entsprechend der nach dem Querreckschritt deutlich vergrößerten Breite des Kunststofffilms größer dimensioniert auszubilden, wenn diese Behandlung ebenfalls über die gesamte Breite des Films erfolgen soll (was wünschenswert ist). Eine solche größere Dimensionierung bringt konstruktiv und apparativ Probleme und Herausforderungen mit sich, insbesondere die Herausforderung, eine solche Behandlung über eine größere Distanz gleichmäßig und homogen auszuführen, so dass der behandelte Kunststofffilm über die nach dem Querrecken vergrößerte Breite eine einheitliche Oberflächeneigenschaft aufweist. Das Erfordernis, die Behandlungseinrichtung für die zweite, nach dem Querrecken durchzuführende Behandlung in verlängerter Dimension auszubilden, führt zudem zu höheren vorrichtungsseitigen Kosten. Auch wird bei größerer Behandlungsstrecke der Verbrauch an Verfahrensmedien erhöht, was sich erhöhend auf die Betriebskosten auswirkt.

Hier soll mit der Erfindung Abhilfe geschaffen werden. Es ist insbesondere Aufgabe der Erfindung, ein Verfahren und eine Vorrichtung zur Beeinflussung von Oberflächeneigenschaften von Kunststofffilmen bzw. Metallfolien anzugeben, welches bzw. welche mit vergleichsweise geringem apparativen Aufwand an unterschiedlichen Stellen des Herstellungs- bzw. Verarbeitungsprozesses der Folien bzw. Filme eingesetzt werden kann. Insbesondere soll es auch möglich sein, mit dem Verfahren bzw. mit der Vorrichtung biaxial gereckte Filme aus thermoplastischen Polymeren bei einer Vereinfachung des Aufbaus zugleich mit ebenfalls gutem Behandlungsergebnis behandeln zu können. Insbesondere soll in einer Variante des Verfahrens die Vorrichtung zu dessen Durchführung einfach in bestehende Anlagen zum Recken von biaxial gereckten Kunststofffilmen integriert werden können, dies auch bei solchen Anlagen, die in einem gemeinsamen Schritt eine Längs- und Querreckung vornehmen.

Gelöst wird diese Aufgabe im Hinblick auf das Verfahren durch ein solches mit den Merkmalen des Anspruchs 1, eine erfindungsgemäße Lösung des vorrichtungsmäßigen Aspektes dieser Aufgabe ist im Anspruch 8 angegeben. Vorteilhafte Weiterbildungen des Verfahrens geben die abhängigen Ansprüche 2 bis 7, solche der Vorrichtung die Ansprüche 9 bis 13 an.

Die wesentliche Erkenntnis der Erfindung liegt darin, dass eine nachhaltige Beeinflussung der Oberflächeneigenschaften von Metallfolien (insbesondere deren Reinigung von bspw. Öl- oder Fettrückständen) bzw. Kunststofffilmen (insbesondere deren Aktivierung zur Verbesserung von Adhäsionseigenschaften) sehr effizient durch eine örtlich in einem gemeinsamen Behandlungsbereich zusammenfallende und gleichzeitige Plasma- und Coronabehandlung erfolgen kann. Die Erfinder haben festgestellt, dass die in einem gemeinsamen Behandlungsbereich zusammenfallende und zudem zeitgleiche Behandlung mit einerseits einer Plasma- andererseits einer Coronabehandlung zu besonders guten Behandlungsergebnissen führt. Zudem bietet diese Vorgehensweise die Möglichkeit des Vorsehens eines kompakten und damit einfach in bestehende Anlagen zu integrierenden bzw. nachzurüstenden apparativen Aufbaus. Es fallen also die Plasma- und Coronabehandlung nicht nur zeitlich, sondern auch örtlich zusammen in einem gemeinsamen Behandlungsbereich.

Die erfindungsgemäß durchgeführte Behandlung kann dabei während der Herstellung einer Metallfolie bzw. eine Kunststofffilms bzw. im unmittelbaren Anschluss daran erfolgen, um gleichermaßen ab Werk entsprechend oberflächenbehandelte Folien bzw. Filme anbieten zu können. So können z.B. derart behandelte Kunststofffilme bereits mit deutlich erhöhter Oberflächenspannung versehen sein, die bspw. für ein zuverlässiges und haltbares Bedrucken erforderlich ist.

Da sich mit der Zeit bei Kunststofffilmen ein Abfall der Oberflächenspannung ergibt, Metallfolien an ihren Oberflächen verunreinigen können, kann es auch von Vorteil und erwünscht sein, wenn die erfindungsgemäße Behandlung unmittelbar vor einer weiteren Verarbeitung der Folie bzw. des Films erfolgt. Dies kann eine erstmalige oder aber auch eine wiederholte Behandlung sein.

Das Verfahren eignet sich insbesondere zur Durchführung an kontinuierlich bewegten und zu behandelnden Folien- bzw. Filmbahnen.

Insbesondere bei einer erfindungsgemäßen Behandlung biaxial gereckter Kunststofffilme aus thermoplastischen Polymeren hat sich herausgestellt, dass entgegen der Annahme der DE 10 2005 052 441 das Ergebnis nicht davon abhängig ist, verschiedene Behandlungsschritte getrennt und zu unterschiedlichen Zeitpunkten des biaxialen Reckens mit einer abschließenden Behandlung erst nach dem Querrecken durchzuführen, sondern dass dies auch mittels einer gleichzeitigen Plasma- und Coronabehandlung möglich ist, die insbesondere vor der Querreckung erfolgt. Eine solche gleichzeitige Behandlung, bei der sowohl ein Plasma gezündet und das Plasma in Richtung der zu behandelnden Oberfläche getrieben wird, als auch eine Coronaentladung im Bereich der Filmoberfläche initiiert wird, kann somit vor dem Querrecken stattfinden, so dass auch bei einer Behandlung des Kunststofffilms über dessen gesamte Breite der apparative Aufbau entsprechend der vor der Querreckung geringeren Breite des Kunststofffilms kürzer ausgebildet werden kann. Somit kann ein entsprechender Verfahrensschritt in bestehenden Reckanlagen für Kunststofffilmbahnen integriert werden, indem eine solche kompakt ausgebildete Vorrichtung dort an geeigneter Stelle beliebig vor dem Querrecken installiert wird. Auch wenn die gleichzeitige und vorzugsweise auch in einem örtlichen Behandlungsbereich zusammenfallende Plasma- und Coronabehandlung vorzugsweise nach der Längsreckung erfolgt, ist dies nicht zwingend erforderlich, sie kann sogar in einem vor dieser Längsreckung liegenden Verfahrensabschnitt durchgeführt werden, somit insbesondere auch in solchen Verfahren zum Recken der Kunststofffilme zum Einsatz gelangen, in denen die Längs- und Querreckungen in einem einzigen gemeinsamen Schritt vollzogen werden.

Hinsichtlich des vorrichtungsgemäßen Aspektes besteht die Lösung der Aufgabe, wie bereits erwähnt, in einer solchen Vorrichtung mit den Merkmalen des Anspruchs 8. Das Besondere an dieser Vorrichtung ist nun, dass in einer kombinierten Anordnung diese wenigstens eine in einem Gehäuse angeordnete Plasmadüse aufweist, die dem Erzeugen und gerichteten Ausblasen eines Plasmastroms dient sowie eine Anordnung für die Zündung einer Coronaentladung, die als eine Elektrode das Gehäuse der Plasmadüse bzw. einen Abschnitt dieses Gehäuses, als zweite Elektrode eine Gegenelektrode aufweist, und einen zum Erzeugen einer Wechselspannung im Hochspannungsbereich (Wechselspannungen mit 1.000 Volt und darüber) dienenden Hochspannungsgenerator. Dieser Generator ist mit seinen Ausgängen einerseits mit dem Gehäuse, welches hinsichtlich des zur Zündung der Coronaentladung dienenden Anteils der Vorrichtung als eine Elektrode dient, bei nur einem Abschnitt des Gehäuses, welches als Elektrode dient, mit diesem Gehäuseabschnitt, verbunden, andererseits mit der Gegenelektrode.

Der Hochspannungsgenerator ist dabei eingerichtet zum Erzeugen der für entsprechende Coronabehandlungen typischen Hochspannungen bei den ebenfalls typischen und üblichen Frequenzen, die sich beispielsweise hinsichtlich der Hochspannung im Bereich zwischen 10 bis 20 KV und hinsichtlich der Frequenz zwischen 10 und 60 kHz bewegen können.

Diese erfindungsgemäße Vorrichtung ist besonders kompakt, die Integration von Plasmadüsen als eigenständiger Plasmagenerator in einem Gehäuse, welches zugleich als eine Elektrode einer Elektrodenanordnung zum Zünden der Coronaentladung dient, ist in höchstem Maße raumsparend, erlaubt dabei zugleich eine effiziente Behandlung der durch diese Anordnung laufenden Folie bzw. des Films bzw. der Folien- oder Filmbahn zugleich mit dem von der Plasmadüse generierten und in Richtung der Folie bzw. des Films ausgeblasenen Plasma sowie mittels der zwischen dem Gehäuse und der Gegenelektrode gezündeten Coronaentladung bzw. der dadurch entstehenden Spezies.

Die Plasmadüse, die in der erfindungsgemäßen Vorrichtung Verwendung findet, kann z.B. eine solche sein, wie sie in der DE 196 48 999 beschrieben ist und von der AFS Entwicklungs- und Vertriebs GmbH unter der Marke PLASMAJET^{®} angeboten und vertrieben wird.

Um eine über die gesamte Breite der zu behandelnden Metallfolie bzw. des zu behandelnden Kunststofffilms reichende Oberflächenbehandlung mit der erfindungsgemäßen Vorrichtung zu erzielen, kann das Gehäuse, welches jedenfalls mit einem einer entsprechenden Folien- bzw. Filmbahn zugewandten Teil als eine Elektrode der Plasmaentladungseinrichtung dient, balkenartig lang ausgestreckt ausgebildet sein, wobei mehrere in seiner Längsrichtung hintereinander daran angeordnete Plasmadüsen vorgesehen sind. Mit einer solchen Mehrzahl von hintereinander angeordneten Plasmadüsen lässt sich ein homogener Plasmastrahl langgestreckter bzw. eine "Plasmawolke" erreichen, der bzw. die wiederum eine gleichmäßige Plasmabehandlung der zu behandelnden Oberfläche über deren gesamte Breite ermöglicht. Ebenso wird mit der Coronaentladung eine gleichmäßige Coronabehandlung der Oberfläche zeitgleich mit der Plasmabehandlung erzielt, indem diese Coronaentladung über die gesamte Breite des Gehäuses zwischen diesem Gehäuse, welches als eine Elektrode dient und der Gegenelektrode gezündet wird.

Die Gegenelektrode kann mit Vorteil mit einem Dielektrikum beschichtet sein. Dadurch wird ein direkter Überschlag zwischen den Elektroden verhindert und bei Einhaltung der entsprechenden je nach Breite des Luftspaltes einzustellenden Randbedingungen (anzulegende Hochspannung und Frequenz) sichergestellt, dass die zwischen dem als Elektrode dienenden Gehäuse bzw. dem Gehäuseabschnitt und der Gegenelektrode zündende Entladung eine Coronaentladung ist.

Die Gegenelektrode kann besonders vorteilhaft eine Walzenelektrode sein. So kann insbesondere bei der Behandlung von Folien- bzw. Filmbahnen diese Walzenelektrode zugleich eine sichere Führung der zu behandelnden Bahn darstellen, indem diese Bahn über die Walzenelektrode läuft und transportiert wird. Liegt die Bahn dabei im unmittelbaren Kontakt auf der Walzenelektrode auf, kann eine Coronabehandlung von der Rückseite vermieden werden, so dass nur die den Plasmadüsen zugewandte Oberfläche der Folie bzw. des Films plasma- und auch coronabehandelt wird. Durch gezieltes Vorsehen eines Luftspaltes kann in einer solchen Vorrichtung neben der Plasma- und Coronabehandlung von der den Plasmadüsen zugewandten Vorderseite der Metallfolien- oder Kunststofffilmbahn auch eine Coronabehandlung auf der Rückseite erfolgen, wenn dies für eine nachfolgende Anwendung der Folie bzw. des Films von Vorteil und daher gewünscht ist.

Je nach Verschaltung insbesondere der Plasmadüsen und je nach Art des zu behandelnden Materials kann das als Elektrode dienende Gehäuse bzw. der entsprechende Gehäuseabschnitt auf Erdpotential, die Gegenelektrode mit einem entsprechenden Hochspannungspotential verbunden sein oder eine umgekehrte Verschaltung vorliegen, bei der die Gegenelektrode geerdet, das Gehäuse bzw. der als Elektrode dienende Gehäuseabschnitt auf Hochspannungspotential gelegt wird.

Erkennbar ist die erfindungsgemäße Vorrichtung kompakt aufzubauen, insbesondere da die Plasmadüsen mit heutigen Technologien besonders klein in der Bauform herzustellen sind, mithin auf engem Raum in ein Gehäuse integriert werden können, das als eine Elektrode der Coronaentladungs-Anordnung als Bestandteil der erfindungsgemäßen Vorrichtung dient. So kann die erfindungsgemäße Vorrichtung entsprechend über die gesamte Breite der zu behandelnden Folie, des zu behandelnden Films bzw. der zu behandelnden Folien- oder Filmbahn ausgedehnt werden.

Bei einer Behandlung eines biaxial gereckten Kunststofffilms vor dem Querrecken kann diese Breite, da vor einem Querrecken bemessen, geringer sein verglichen mit der nach dem Recken in Querrichtung für eine Flamm- oder Coronabehandlung in dem Verfahren gemäß der DE 10 2005 052 441 vorzusehenden Breite der entsprechenden Einrichtung.

Weitere Vorteile und Merkmale ergeben sich aus der nachfolgenden Beschreibung eines Ausführungsbeispiels anhand der beigefügten Figuren. Dabei zeigen:
- Fig. 1: eine schematische Darstellung einer erfindungsgemäßen Vorrichtung während der erfindungsgemäßen Durchführung eines entsprechenden Behandlungsverfahrens in einer ersten möglichen Beschaltung; und
- Fig. 2: eine der Fig. 1 vergleichbare schematische Darstellung einer erfindungsgemäßen Vorrichtung in umgekehrter Verschaltung.

In den Figuren ist eine erfindungsgemäße Vorrichtung in höchst schematischer Weise dargestellt, wie sie zur Behandlung einer Metallfolien- bzw. Kunststofffilmbahn aufgebaut und verschaltet ist und arbeitet.

Die erfindungsgemäße Vorrichtung setzt sich zusammen aus einer Kombination zwischen Plasmadüsen als Plasmaquelle sowie einer aus Elektrode und Gegenelektrode bestehenden Anordnung zur Coronaentladung. Plasmadüsen 1 sind in nicht näher dargestellter Weise in einer Anordnung senkrecht zur Zeichenebene hintereinander angeordnet innerhalb eines diese Plasmadüsen 1 fassenden Gehäuses 2. Das Gehäuse 2 dient, jedenfalls in seinem in der Figur unten dargestellten Abschnitt als eine Elektrode einer Coronaentladungseinrichtung und ist über einen Anschluss 3 mit einem hier nicht näher dargestellten Hochspannungsgenerator verbunden. Als Gegenelektrode der Coronaentladungseinrichtung dient in diesem Ausführungsbeispiel eine Walzenelektrode 4, bei der es sich um eine mit Dielektrikum beschichtete metallische Trägerwalze handelt. Auch diese ist in hier nicht näher dargestellter Weise mit dem Hochspannungsgenerator verbunden, mit dessen zweiten Ausgang.

Im Betrieb läuft über die Walzenelektrode 4 eine Bahn 5 einer Metallfolie oder eines Kunststofffilms und wird auf der der Walzenelektrode 4 abgewandten, den Plasmadüsen 1 bzw. dem Gehäuse 2 zugewandten Weise örtlich und zeitlich zusammenfallend einer Plasma- und einer Coronabehandlung unterzogen. Hierfür wird in den Plasmadüsen 1 im Inneren erzeugtes Plasma als Plasmastrom 6 aus den Plasmadüsen 1 ausgeblasen gegen die Oberfläche der zu behandelnden Folien- bzw. Filmbahn 5. Zugleich zündet durch Anlegen der hochfrequenten Wechselspannung im Hochspannungsbereich zwischen dem Gehäuse 2 und der Walzenelektrode 4 eine Coronaentladung, die hier mit 7 veranschaulicht ist. Auch diese Coronaentladung 7 wirkt auf die Oberfläche der Folien- bzw. Filmbahn 5 ein.

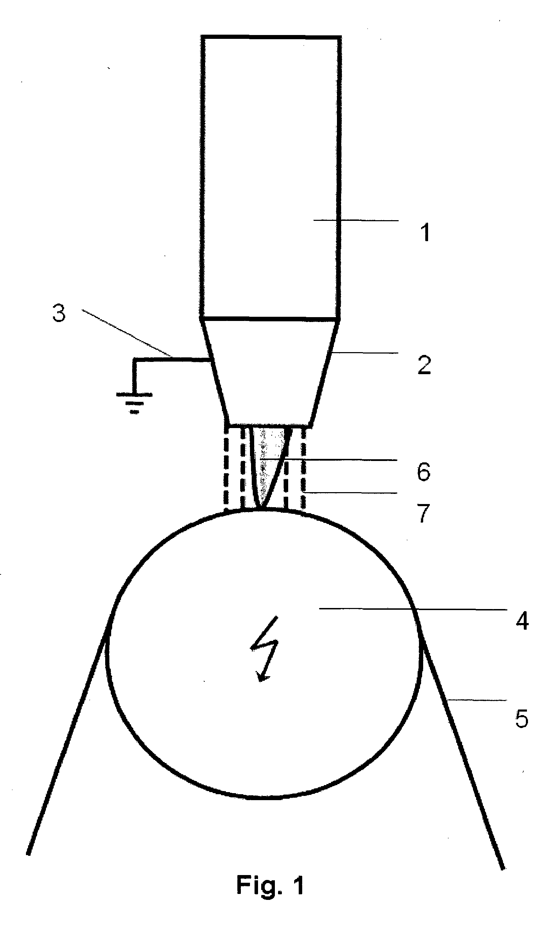

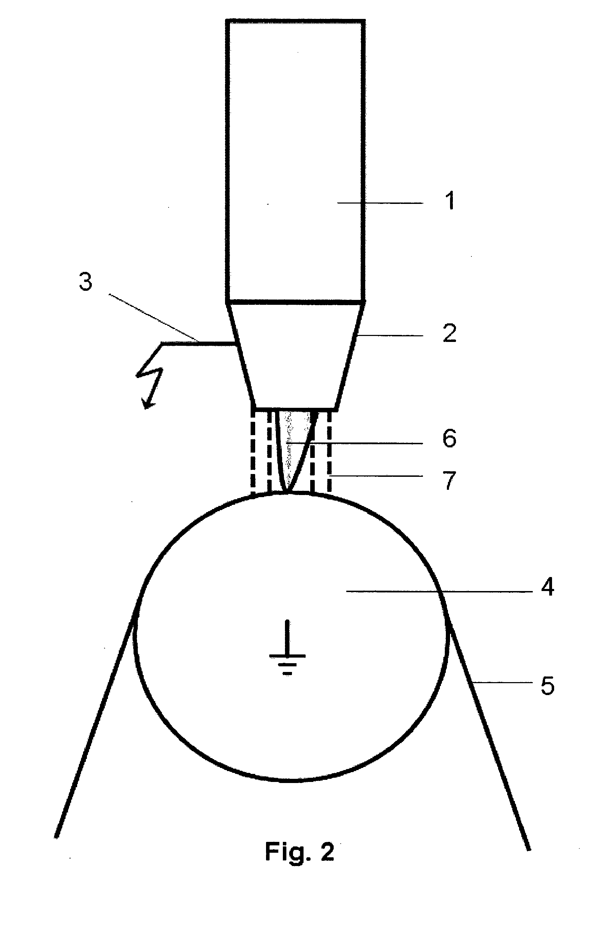

Insoweit sind die Figuren 1 und 2 in ihrer jeweiligen Darstellung identisch, sie unterscheiden sich lediglich durch die Beschaltung des als Elektrode dienenden Gehäuses (Gehäusabschnittes) 2 und der Walzenelektrode 4. Während in Fig. 1 das Gehäuse 2 auf Erdpotential, die Walzenelektrode 4 auf Hochspannung gelegt ist, ist die Beschaltung in Fig. 2 gerade umgekehrt ausgeführt. Prinzipiell sind für eine Coronaentladung beide Beschaltungsvarianten möglich. Im Falle der Oberflächenbehandlung einer Metallfolienbahn mit der beschriebenen Vorrichtung wird allerdings eine Beschaltung gemäß Fig. 2 zu wählen sein, um zu verhindern, dass an der Walzenelektrode 4 anliegende Spannung in weitere (hier nicht gezeigte) Komponenten des gesamten Systems eingeleitet wird.

Bei der Oberflächenbehandlung von - elektrisch isolierenden - Kunststofffilmen besteht dieses Problem nicht. Hier wird im Hinblick auf die eingesetzten Plasmadüsen 1 und deren Arbeitsweise die elektrisch günstigere Beschaltungsweise zu wählen sein.

Bei den hier nicht näher dargestellten und erläuternden Plasmadüsen 1 handelt es sich vorzugsweise um solche des Typs und der Wirkweise, wie sie in der DE 196 48 999 beschrieben ist.

Eine Behandlung einer Kunststofffilmbahn während seiner Herstellung mit der in den Figuren gezeigten Vorrichtung erfolgt erfindungsgemäß vor einem Querrecken der so behandelten Filmbahn 5, kann dabei insbesondere nach einem Längsreckschritt erfolgen, aber auch vor einem solchen.

Die elektrische Verschaltung der Plasmadüsen 1 ist in dem Gehäuse 2 integriert und hier nicht näher dargestellt. Sie erfolgt entsprechend den Anforderungen dieser Elemente und zwar so, dass sie mit dem Anschluss des Gehäuses an den Hochspannungsgenerator zu dessen Nutzung als Elektrode für die Coronaentladung 7 nicht kollidiert.

### Bezugszeichenliste

- 1: Plasmadüse
- 2: Gehäuse
- 3: Anschluss
- 4: Walzenelektrode
- 5: Metallfolien- bzw. Kunststofffilmbahn
- 6: Plasmastrom
- 7: Coronaentladung

## Patentansprüche

1. Verfahren zur Beeinflussung von Oberflächeneigenschaften von Metallfolien und Kunststofffilmen, wobei die Oberfläche der Folie bzw. des Films auf wenigstens einer Seite einer örtlich in einem gemeinsamen Behandlungsbereich zusammenfallenden, gleichzeitig stattfindenden Plasma- und Coronabehandlung unterzogen wird.

2. Verfahren nach Anspruch 1, **dadurch gekennzeichnet, dass** die örtlich in einem gemeinsamen Behandlungsbereich zusammenfallende, gleichzeitig stattfindende Plasma- und Coronabehandlung im Zuge der Herstellung der Folie oder des Filmes oder unmittelbar im Anschluss an diese erfolgt.

3. Verfahren nach einem der vorhergehenden Ansprüche, **dadurch gekennzeichnet, dass** die örtlich in einem gemeinsamen Behandlungsbereich zusammenfallende, gleichzeitig stattfindende Plasma- und Coronabehandlung unmittelbar vor einer weiteren Bearbeitung der Folie bzw. des Films erfolgt.

4. Verfahren nach einem der vorhergehenden Ansprüche, **dadurch gekennzeichnet, dass** es kontinuierlich erfolgt, wozu die Folie oder der Film als Bahn in der Längsrichtung relativ zu einer Vorrichtung für die örtlich in einem gemeinsamen Behandlungsbereich zusammenfallende, gleichzeitige Plasma- und Coronabehandlung bewegt wird.

5. Verfahren nach einem der vorhergehenden Ansprüche, **dadurch gekennzeichnet, dass** bei einem biaxial gereckten Film aus einem thermoplastischen Polymer, dessen Reckung als Längsreckung in einer Längsrichtung und als Querreckung in einer quer, insbesondere senkrecht, zu der Längsrichtung verlaufenden Querrichtung erfolgt, in einem Schritt vor der Querreckung die Oberfläche des Kunststofffilms auf wenigstens einer Seite einer gleichzeitig stattfindenden Plasma- und Coronabehandlung unterzogen wird.

6. Verfahren nach Anspruch 5, **dadurch gekennzeichnet, dass** die gleichzeitige Plasma- und Coronabehandlung über die gesamte in Querrichtung verlaufende Breite des noch nicht quer gereckten Kunststofffilms erfolgt.

7. Verfahren nach einem der vorhergehenden Ansprüche, **dadurch gekennzeichnet, dass** die gleichzeitige Plasma- und Coronabehandlung nach der Längsreckung erfolgt.

8. Vorrichtung zur Beeinflussung von Oberflächeneigenschaften von Oberflächen von Metallfolien und Kunststofffilmen (5) durch gleichzeitige Plasma- und Coronabehandlung, mit wenigstens einer in einem Gehäuse (2) angeordneten Plasmadüse (1) zum Erzeugen und gerichteten Ausblasens eines Plasmastroms (6) durch einen Düsenaustritt, einer dem Düsenaustritt gegenüberliegenden Gegenelektrode (4) und mit einem Hochspannungsgenerator zum Erzeugen einer Wechselspannung im Hochspannungsbereich, wobei der Hochspannungsgenerator mit seinen Ausgängen zum Erzeugen einer Potentialdifferenz einerseits mit dem Gehäuse (2) und andererseits mit der Gegenelektrode (4) verbunden ist.

9. Vorrichtung nach Anspruch 8, **dadurch gekennzeichnet, dass** das Gehäuse (2) balkenartig langgestreckt ausgebildet ist mit mehreren in seiner Längsrichtung hintereinander darin angeordneten Plasmadüsen (1).

10. Vorrichtung nach einem der Ansprüche 8 oder 9, **dadurch gekennzeichnet, dass** die Gegenelektrode (4) mit einem Dielektrikum beschichtet ist.

11. Vorrichtung nach einem der Ansprüche 8 bis 10, **dadurch gekennzeichnet, dass** die Gegenelektrode (4) eine Walzenelektrode ist.

12. Vorrichtung nach einem der Ansprüche 8 bis 11, **dadurch gekennzeichnet, dass** der Hochspannungsgenerator mit einem geerdeten Ausgang mit dem Gehäuse verbunden ist.

13. Vorrichtung nach einem der Ansprüche 8 bis 11, **dadurch gekennzeichnet, dass** der Hochspannungsgenerator mit einem geerdeten Ausgang mit der Gegenelektrode verbunden ist.

## Claims

1. A method for influencing surface properties of metal foils and synthetic material films, wherein the surface of the foil or of the film is subjected on at least one side to a local, coinciding plasma and corona treatment, taking place simultaneously in a common treatment area.

2. The method according to claim 1, **characterised in that** the local, coinciding plasma and corona treatment taking place simultaneously in a common treatment area Is carried out during the manufacture of the foil or of the film or immediately thereafter.

3. The method according to any of the preceding claims, **characterised in that** the local, coinciding plasma and corona treatment taking place simultaneously in a common treatment area is carried out immediately before a further process of the foil or of the film.

4. The method according to any of the preceding claims, **characterised in that** it is carried out continuously, whereby the foil or the film is moved as a band in the longitudinal direction with respect to a device for the local, coinciding plasma and corona treatment taking place simultaneously in a common treatment area.

5. The method according to any of the preceding claims, **characterised in that** in the case of a biaxially stretched film of thermoplastic polymer, which is stretched in a longitudinal direction for the longitudinal stretching and in a direction transversal, in particular vertical to the longitudinal direction, the surface of the synthetic film is subjected to a step prior to the transversal stretching, on at least one side, to a plasma and corona treatment taking place simultaneously.

6. The method according to claim 5, **characterised in that** the simultaneous plasma and corona treatment takes place over the whole width extending in transversal direction of the synthetic film which has not been stretched yet.

7. The method according to any of the preceding claims, **characterised in that** the simultaneous plasma and corona treatment takes place after the longitudinal stretching.

8. The method for influencing surface properties of metal foils and synthetic material films (5) by simultaneous plasma and corona treatment, having at least one plasma nozzle (1) arranged in a housing (2) for generating and directing the discharge of a plasma current (6) through a nozzle outlet, a counter-electrode (4) opposite the nozzle outlet and a high voltage generator for generating an alternate voltage in the high tension region, whereas the high voltage generator is connected with its outputs on the one hand to the housing (2) and on the other hand to the counter-electrode (4) for generating a potential difference.

9. The method according to claim 8, **characterised in that** the housing (2) is stretched longitudinally in the form of a beam, with several plasma nozzles (1) arranged therein behind one another in its longitudinal direction.

10. The device according to one of the claims 8 or 9, **characterised in that** the counter-electrode (4) is coated with a dielectric.

11. The device according to one of the claims 8 to 10, **characterised in that** the counter-electrode (4) is a roller electrode.

12. The device according to one of the claims 8 to 11, **characterised in that** the high voltage generator is connected with its grounded output to the housing.

13. The device according to one of the claims 8 to 11, **characterised in that** the high voltage generator is connected with its grounded output to the counter-electrode.

## Revendications

1. Procédé permettant d'influencer les propriétés de surface de feuilles de métal et de feuilles de matériaux synthétiques, où la surface de la feuille ou du film est soumise sur au moins un côté à un traitement plasma et corona local coïncidant appliqué simultanément à une zone de traitement commune.

2. Procédé selon la revendication 1, **caractérisé en ce que** le traitement plasma et corona local coïncidant appliqué simultanément à une zone de traitement commune se produit pendant la fabrication de la feuille ou du film ou bien juste après.

3. Procédé selon l'une quelconque des revendications précédentes, **caractérisé en ce que** le traitement plasma et corona local coïncidant appliqué simultanément à une zone de traitement commune se produit juste avant une autre phase de traitement de la feuille ou du film.

4. Procédé selon l'une quelconque des revendications précédentes, **caractérisé en ce qu'**il se produit en continu, dans la mesure où la feuille ou le film se déplace sous forme de bande longitudinalement par rapport à un dispositif pour le traitement plasma et corona local coïncidant appliqué simultanément à une zone de traitement commune.

5. Procédé selon l'une quelconque des revendications précédentes, **caractérisé en ce que** dans le cas d'un film étiré biaxialement composé d'un polymère thermoplastique, dont l'étirage prend la forme d'un étirage longitudinal dans une direction longitudinale ou comme étirage transversal dans une direction transversale, s'étendant en particulier perpendiculaire à la direction longitudinale, la surface du film de matériau synthétique est soumise en une phase avant l'étirage transversal sur au moins un côté à un traitement plasma et corona se déroulant simultanément.

6. Procédé selon la revendication 5, **caractérisé en ce que** le traitement plasma et corona simultané se produit sur toute la largeur s'étendant dans la direction transversale du film de matériau synthétique non encore étiré transversalement.

7. Procédé selon l'une quelconque des revendications précédentes, **caractérisé en ce que** le traitement plasma et corona simultané se produit après l'étirage longitudinal.

8. Procédé permettant d'influencer les propriétés de surface de feuilles de métal et de feuilles de matériaux synthétiques (5) par traitement plasma et corona simultané comportant au moins une buse plasma (1) disposée dans un logement (2) pour générer et souffler un courant de plasma (6) à travers une sortie de buse, une contre-électrode (4) opposée à la sortie de buse et un générateur haute tension permettant de générer une tension alternative dans la zone haute tension, où le générateur haute tension est relié d'une part au logement (2) et d'autre part à la contre-électrode (4), par ses sorties permettant de générer une différence de potentiel.

9. Dispositif selon la revendication 8, **caractérisé en ce que** le logement (2) est étiré en longueur en forme de poutre avec plusieurs buses plasma (1) disposées l'une derrière l'autre dans sa direction longitudinale.

10. Dispositif selon l'une des revendications 8 ou 9, **caractérisé en ce que** la contre-électrode (4) est recouverte d'un diélectrique.

11. Dispositif selon l'une des revendications 8 à 10, **caractérisé en ce que** la contre-électrode (4) est une électrode-rouleau.

12. Dispositif selon l'une des revendications 8 à 11, **caractérisé en ce que** le générateur haute tension est relié au logement par sa sortie mise à la terre.

13. Dispositif selon l'une des revendications 8 à 11, **caractérisé en ce que** le générateur haute tension est relié à la contre-électrode par sa sortie mise à la terre.
